# EUROPÄISCHE PATENTSCHRIFT

(11) **EP 2 884 665 B1**
(45) Veröffentlichungstag und Bekanntmachung des Hinweises auf die Patenterteilung: **27.04.2016**
(21) Anmeldenummer: 14004037.9
(22) Anmeldetag: 29.11.2014
(51) Int. Cl.: H03K 19/0175, H03K 19/173

(54) **Konfigurierbare Schnittstellenschaltung**
Configurable interface circuit
Commutation d'interface configurable

(30) Priorität: 11.12.2013 DE 102013020803; 22.08.2014 DE 102014012660
(43) Veröffentlichungstag der Anmeldung: 17.06.2015
(73) Patentinhaber: Diehl Aerospace GmbH, 88662 Überlingen (DE)
(72) Erfinder: Späh, Jürgen, DE - 88662 Überlingen (DE)
(74) Vertreter: Diehl Patentabteilung

(56) Entgegenhaltungen:
- EP-A1- 0 620 510
- EP-A2- 1 571 510
- DE-U1- 20 205 551

## Beschreibung

Die Erfindung betrifft eine Schnittstellenschaltung - auch Schnittstelle oder Interface genannt - zwischen einer Logikschaltung (Logikteil einer elektrischen Schaltung) und einer Leistungsschaltung (Leistungsteil der Schaltung), insbesondere zum Einsatz in einem Flugzeug. Der Leistungsteil der Schaltung ist z.B. eine anzusteuernde Last, z.B. ein Motor, der dann an einem Leistungsausgang der Schnittstelle angeschlossen ist. Oder er ist ein auszulesendes elektrisches Element, z.B. ein Schalter, dessen Schaltzustand zu erfassen ist oder eine Stromleitung, deren Stromfluss zu messen ist, das dann an einem Leistungseingang der Schnittstelle angeschlossen ist. Die Schnittstelle ist in der Regel mit einer Energieversorgung verbunden, um leistungsschwache Logiksignale und leistungsintensive Lastsignale ineinander umzusetzen.

Bekannt ist es, für die Ausgangsfunktionalität spezielle DSO(Discrete Output)-Schnittstellen und für die Eingangsfunktionalität spezielle DSI(Discrete Input)-Schnittstellen zu verwenden. Bekannt sind DSO-Schnittstellen in Form einer Halbbrücke mit Halbleiterschaltern. Die Ansteuerung der Halbbrücke erfolgt vom Logikteil aus. Der Mittenanschluss der Halbbrücke bildet den Leistungsausgang für die Beschaltung des Leistungsteils. Die Energieversorgung ist an den oberen bzw. unteren Enden der Halbbrücke (Versorgungsanschluss) angeschlossen.

Bekannt ist es auch, mehrere Schnittstellen in einem Schnittstellenmodul zusammenzufassen. Das Schnittstellenmodul verfügt dann über eine bestimmte Zahl, z.B. drei, Leistungsausgänge, die ausschließlich eine Ausgangsfunktion besitzen und über eine bestimmte Zahl, z.B. zwei, Leistungseingänge, die ausschließlich eine Eingangsfunktion besitzen. Jedem der Leistungsausgänge ist eine spezielle DSO-Schnittstelle und jedem der Leistungseingänge eine spezielle DSI-Schnittstelle zugeordnet. In Systemen werden derartige Module oft derart eingesetzt, dass mindestens einer der Anschlüsse ungenutzt bleibt. Dies ist z.B. aus Kosten-, Ressourcen-, Platz- und Gewichtsgründen nachteilig.

Aus der EP 0 620 510 A1 ist es bekannt, eine Schnittstelle zum Senden und/oder Empfangen digitaler Signale konfigurierbar auszuführen. Hierzu wird ein Application Specific Integrated Circuit (ASIC) durch die Kombination eines universellen Microcontrollers und eines Field Programmable Gate Arrays (FPGA) oder einer vergleichbaren Schaltungen ersetzt. Für analog arbeitende Leistungsteile oder solche mit hoher Leistung, wie z.B. Motoren o.ä. ist eine derartige Schnittstelle nicht geeignet.

Aus der EP 1 571 510 A2 ist eine universelle Eingangs- / Ausgangsvorrichtung für ein industrielles Automatisierungs-Steuersystem bekannt. Die Geräte-Setup-Steuerschaltung führt einen Initialisierungsprozess durch, um die Vorrichtung zu konfigurieren als: ein eigenständiges Block-I/O-Gerät, ein Netzwerkadaptermodul eines modularen I/O-Gerätes oder ein I/O-Modul eines modularen I/O-Gerätes.

Aufgabe der vorliegenden Erfindung ist es, eine verbesserte Schnittstellenschaltung und ein verbessertes Schnittstellenmodul anzugeben. Die Aufgabe wird hinsichtlich der Schnittstellenschaltung durch eine Schnittstellenschaltung gemäß Patentanspruch 1 gelöst.

Die Schnittstellenschaltung dient zur Zwischenschaltung zwischen eine Logikschaltung und eine Leistungsschaltung. Die Schnittstellenschaltung weist einen Versorgungsanschluss zum Anschluss an eine Energieversorgung auf. Die Schnittstellenschaltung enthält zwei Logikanschlüsse. Jeder der Logikanschlüsse dient zum Anschluss an eine jeweilige Logikschaltung. Jeder der Logikanschlüsse ist entweder als Logikeingang oder als Logikausgang konfigurierbar. Die Schnittstelle weist außerdem zwei Leistungsanschlüsse auf. Jeder der Leistungsanschlüsse dient jeweils zum Anschluss an eine Leistungsschaltung. Jeder der Leistungsanschlüsse ist entweder als Leistungseingang oder als Leistungsausgang konfigurierbar. Die Schnittstellenschaltung weist eine Konfigurationseinheit auf, die zur Konfiguration der Logikanschlüsse und der Leistungsanschlüsse dient. Bei der Schnittstellenschaltung ist jeder der Leistungseingänge durch einen der Logikausgänge auslesbar und jeder der Leistungsausgänge ist durch einen der Logikeingänge ansteuerbar.

Die beschriebene Schnittstellenschaltung stellt hinsichtlich der Anzahl der Logik- und Leistungsanschlüsse eine minimale Ausführungsform dar. Weitere Versorgungs-, Logik- oder Leistungsanschlüsse der oben Art im Sinne der Erfindung geschilderten Art können vorhanden sein.

Die Schnittstellenschaltung bietet den Vorteil, dass zwei Leistungsanschlüsse vorhanden sind, die je nach Bedarf als Leistungseingang oder Leistungsausgang konfigurierbar und damit ansteuerbar oder auslesbar sind. Damit können in einem elektrischen System durch die Verwendung einer hinreichenden Anzahl identischer erfindungsgemäßer Schnittstellenschaltungen gerade so viele Schnittstellen vorgesehen werden, dass die gesamte Anzahl an Ein- und Ausgängen abgedeckt ist. Allenfalls bleibt ein einziger Leistungsanschluss ungenutzt. Es ergibt sich eine Reduktion der Gesamtzahl der Schnittstellen auf Systemebene durch die unterschiedlichen Einsatzmöglichkeiten der versatilen, d.h. vielseitig einsetzbaren, und konfigurierbaren Schnittstellenschaltung. So werden die Schnittstellenressourcen nahezu voll oder voll ausgenutzt. Da allenfalls eine ungenutzte Schnittstelle vorhanden ist, sinkt der Platz- und Gewichtsbedarf, was insbesondere in der Luftfahrttechnik von großem Vorteil ist, und damit auch die Kosten für die systemweiten Schnittstellen. Die vielseitig einsetzbare bzw. bedarfsgerecht konfigurierbare Schnittstellenschaltung dient damit zur Ansteuerung von Lasten bzw. Motoren und zur digitalen und analogen Signalerfassung. Durch die Konfigurierbarkeit können verschiedene Funktionalitäten, aber auch Wertebereiche von erzeugten oder erfassten elektrischen Größen realisiert werden.

Durch die Konfigurierbarkeit der Leistungsanschlüsse kann eine gewünschte Funktionalität auf beliebige der Anschlüsse geschaltet werden, was eine sogenannte "Switch-Funktionalität" sicherstellt. Mit anderen Worten ist ein Signalrouting innerhalb der Schnittstellenschaltung möglich.

Durch die Vielseitigkeit ist die Ansteuerung von Motoren, z.B. Stepper- oder BLDC(Brushless DC)-Motoren möglich. Messfunktionalitäten sind in der Schnittstellenschaltung realisierbar. So kann eine autonome Erkennung von Motortypen oder - konfigurationen erfolgen. Durch die Konfigurationseinheit ist eine Erhöhung der Messgenauigkeit innerhalb der Schnittstellenschaltung durch z.B. Kalibration oder Temperaturkompensation möglich (per Software, z.B. Lookup-Tabelle).

Die Schnittstellenschaltung ist universell einsetzbar. Es ergibt sich eine Reduktion der Gerätevielfalt durch Versatilität und Konfigurierbarkeit. Die Schnittstellenschaltung ist in unterschiedlichen Systemen universell einsetzbar. Durch die Routingfunktion ergibt sich eine Reduktion und Optimierung der Verkabelung, insbesondere in einem Flugzeug.

Die Schnittstellenschaltung ist als Halbbrückenschaltung ausgeführt. Diese weist einen Schaltzweig auf, der von einem ersten (oberen) zu einem zweiten (unteren) Versorgungsanschluss führt. Der Schaltzweig enthält in Reihenschaltung:
- ein erstes (oberes, TOP, High-Side) und ein zweites (unteres, BOT, Low-Side) Brückenelement, das jeweils von der Konfigurationseinheit konfigurierbar ist. Je nach Konfiguration ist jedes der Brückenelemente von einem Logikeingang ansteuerbar oder von einem Logikausgang auslesbar oder sonst nutzbar.
- einen Trennschalter, der zwischen erstem und zweitem Brückenelement angeordnet ist. Der Trennschalter ist von der Konfigurationseinheit schaltbar, d.h. kann geöffnet oder geschlossen werden;
- den ersten Leistungsanschluss, der zwischen erstem Brückenelement und Trennschalter angeordnet ist; und
- den zweiten Leistungsanschluss, der zwischen zweitem Brückenelement und Trennschalter angeordnet ist.

Durch die Realisierung als Halbbrücke ergeben sich bei geschlossenem (leitendem) Trennschalter die bekannten Vorteile von Halbbrückenschaltungen auch für die erfindungsgemäße Schnittstelle. Insbesondere können mehrere Halbbrücken zu einer Vollbrücke oder noch komplexeren Schaltungen zusammengeschlossen werden. Hierzu sind die Brückenelemente mit einer Schaltfunktion ausgerüstet. Beide Leistungsanschlüsse sind dann direkt verbunden, so dass physikalisch zwei Anschlüsse für zwei Leistungsteile zur Verfügung stehen. Bei der Beschaltung als digitaler Leistungseingang ergibt sich hier eine "Wired-OR" Funktionalität, die jedoch extern physikalisch auf zwei Anschlüsse geführt ist. In der Flugzeugtechnik kann so eine erlaubte Beschaltung durchgeführt werden, da die Beschaltung eines einzelnen Anschlusses mit zwei Leitungen verboten ist.

Durch die Integration eines Trennschalters in der "Mitte" der Halbbrücke kann der obere (sogenannter TOP-Teil) vom unteren Halbbrückenteil (sogenannter BOT-Teil) auch vollständig abgetrennt werden. So entstehen zwei separate Schaltungsteile in der Schnittstelle, die mit je einem der Leistungsanschlüsse verbunden sind. Beide Schaltungsteile sind vollständig unabhängig voneinander betreibbar und nutzbar.

So ist die o.g. Switch-Funktionalität möglich: Durch Öffnen bzw. Schließen des Schalters kann jeder der beiden Leistungsanschlüsse entweder dem TOP- oder dem BOT-Teil der Halbbrücke zugeordnet werden. Insbesondere können herkömmliche DSO-Funktionen über die Switch-Funktionalität geroutet werden: Z.B. kann eine DSO-Highside am Lowside-Leistungsausgang, oder eine DSO-Lowside kann am Highside-Leistungsausgang verfügbar sein.

Die Brückenelemente als Schaltelemente können im ON-, OFF- oder PWM-Betrieb genutzt werden. Im PWM-Betrieb ist bei entsprechend ausgestalteten Brückenelementen auch eine Strommessung möglich. Durch entsprechende Ausgestaltung des Trennschalters ist auch eine Strommessung durch den Trennschalter über die Spannungsdifferenz zwischen beiden Leistungsanschlüssen möglich.

Es ergibt sich also eine konfigurierbare versatile Halbbrücke, die verwendbar ist als: DSO-Highside und/oder DSO-Lowside, als Switch, zum Routing von DSO zu verschiedenen Leistungsausgängen (in Form von "Pins"), "Wired-OR-Funktion" für High-Side und/oder Low-Side, als Isolations-Switch für High-Side oder Low-Side-DSO, als Motorsteuerung, insbesondere für Stepper, BLDC oder Bürsten-Motoren, als DSI mit Verbindung zum unteren oder oberen Potential der Energieversorgung (z.B. DSI-GND-OPEN und/oder DSI-28V-OPEN bei 28V-Spannungsversorgung) oder als analoger Eingang (z.B. von 0V bis 32V).

Ein nicht als "aktiver" Leistungs-Ein- oder Ausgang genutzter Leistungsanschluss bzw. TOP- oder BOT-Zweig der Halbbrücke kann als "Built-In-Test-Funktion" (BIT) verwendet werden. Z.B. kann bei Konfiguration des einen Halbbrückenteils als DSO die nicht genutzt DSI-Funktion des anderen Halbbrückenteils als Überwachungsfunktion des DSO eingesetzt werden. Bei Konfiguration des einen Halbbrückenteils als DSI kann die nicht genutzte DSO-Funktion des anderen Halbbrückenteils zur Erzeugung eines Stimulus bzw. einer Testfunktion für die DSI-Funktion eingesetzt werden.

In einer bevorzugten Variante dieser Ausführungsform enthält jedes der Brückenelemente mindestens einen, insbesondere mindestens zwei in Reihe geschaltete, steuerbare Halbleiterschalter. Durch die Verwendung von Halbleiterschaltern ergeben sich gerade in Bezug auf die Erfindung vielfältige Möglichkeiten, deren elektrische Haupt- oder Parasitäreigenschaften durch gezielte Beschaltung bzw. Ansteuerung mit Hilfe der Konfigurationseinheit gezielt einzusetzen. So können z.B. parasitäre Dioden als Messelemente für Ströme durch die betreffenden Halbleiterschalter genutzt werden, eine Strommessung im PWM-Betrieb oder eine konfigurierbare Strombegrenzung im Schaltzweig durch Ansteuerung des Halbleiterschalters realisiert werden.

In einer bevorzugten Variante dieser Ausführungsform enthält mindestens einer der Halbleiterschalter einen MOS-FET mit parasitärer Substratdiode. Insbesondere wenn in einem Brückenelement zwei MOS-FETs in Reihe geschaltet sind, kann der eine primär als Schalter (Diode ist tatsächlich "nur" parasitär), der andere primär als steuerbares Diodenelement (parasitäre Diode wird durch den Halbleiterschalter in ihren Eigenschaften "konfiguriert") genutzt werden.

In einer bevorzugten Variante dieser Ausführungsform ist daher mindestens einer der Halbleiterschalter in Verbindung mit der Konfigurationseinheit derart eingerichtet, dass durch dessen Ansteuerung die elektrischen Eigenschaften seiner parasitären Substratdiode als steuerbare Diode gezielt festgelegt sind.

So ergibt sich insbesondere eine Testfunktionalität zur Überprüfung der Body-Dioden des Dioden-MOS-FETs, d.h. eine Testbarkeit der Substratdiode durch Änderung der Diodenkonfigurationsspannung. Auch kann die Diode als Messelement für den Strom durch den Schalter verwendet werden. Durch Konfiguration der Ansteuerung des Diode-FET ist dieser als Messwiderstand oder automatische Diode/konfigurierbares Strommesselement zu verwenden. Per Konfiguration sind zwei Strommessmethoden (R_{DS} oder U_{GS}) möglich. Eine Umschaltung von Messbereichen bzw. eine adaptive Messbereichsanpassung sind möglich. Durch Linearbetrieb ist eine Strombegrenzung möglich.

Ein MOS-FET kann dabei eine herkömmliche Diode mit ohmschem Vorwiderstand ersetzen. Der Strom durch einen Switch kann über die Spannung U_{GS} der Switchansteuerung gemessen werden. Die Strommessung für die Switchfunktion ist konfigurierbar über eine Regelung der U_{GS} Switch Spannung. Die Diode ist schaltbar als Widerstand für einen Motorbetrieb. Im Lastpfad ergibt sich eine minimale Stromaufnahme. Die Erfindung kann als Vorrichtung zum Messen eines Laststromes bei geringer Leistungsaufnahme und optimierter MTBF und,Fläche genutzt werden.

In einer weiteren bevorzugten Ausführungsform enthält der Trennschalter zwei in Reihe angeordnete, steuerbare Halbleiterschalter. Insbesondere enthalten die Halbleiterschalter jeweils MOS-FETs mit jeweiliger parasitärer Substratdiode, wobei deren Substratdioden bezüglich der Reihenschaltung entgegengesetzt gerichtet sind Somit ergeben sich auch für den Trennschalter die o.g. Vorteile.

Hinsichtlich des Schnittstellenmoduls wird die Aufgabe gelöst durch ein Schnittstellenmodul gemäß Patentanspruch 8. Dieses enthält mit mindestens zwei Leistungsanschlüsse. Das Schnittstellenmodul enthält mindestens eine erfindungsgemäße Schnittstellenschaltung, deren Leistungsanschlüsse auf die Leistungsanschlüsse des Schnittstellenmoduls geführt sind.

Die Vorteile der Schnittstellenschaltung ergeben sich damit auch für das Schnittstellenmodul. Insbesondere ist das Modul konfigurierbar und daher in beliebiger Weise verwendbar, so dass dessen Leistungsanschlüsse nur umkonfiguriert und nicht ungenutzt bleiben müssen, wenn auf Systemebene ein bestimmter Typ Leistungsanschluss benötigt wird.

In einer bevorzugten Ausführungsform sind im Modul zusätzliche Leistungsanschlüsse in Form von Leistungsein- oder -ausgänge vorgesehen, wobei das Schnittstellenmodul für jeden dieser Leistungsanschlüsse eine spezielle Eingangs- oder Ausgangsschnittstelle enthält. Der Leistungsanschluss ist dann fest als Ein- oder Ausgang ausgeführt und nicht in einen Aus- oder Eingang umkonfigurierbar. Solche speziellen Schnittstellen sind kostengünstiger als die universelle erfindungsgemäße Schnittstelle. Da auf Systemebene in der Regel ohnehin eine Mindestanzahl an dedizierten Leistungsein- und -ausgängen benötigt werden, können zumindest diese kostengünstig realisiert werden. Die restlichen Schnittstellen können dann flexibel gemäß der Erfindung bereitgestellt werden.

Weitere Merkmale, Wirkungen und Vorteile der Erfindung ergeben sich aus der nachfolgenden Beschreibung eines bevorzugten Ausführungsbeispiels der Erfindung sowie der beigefügten Figuren. Dabei zeigen:
- Figur 1: ein erfindungsgemäßes Schnittstellenmodul mit erfindungsgemäßer Schnittstellenschaltung,
- Figur 2: das Schnittstellenmodul aus Fig. 1 in alternativer Konfiguration und Beschaltung,
- Figur 3: die Schnittstellenschaltung aus Figs. 1 und 2, ausgeführt als Halbbrücke,
- Figur 4: eine Tabelle möglicher Konfigurationen der Halbbrücke aus Fig. 3,
- Figur 5: mögliche Verwendungen bzw. Kombinationen der Halbbrücke aus Fig. 3,
- Figur 6: die Halbbrückenschaltung aus Fig. 3 im Detail.

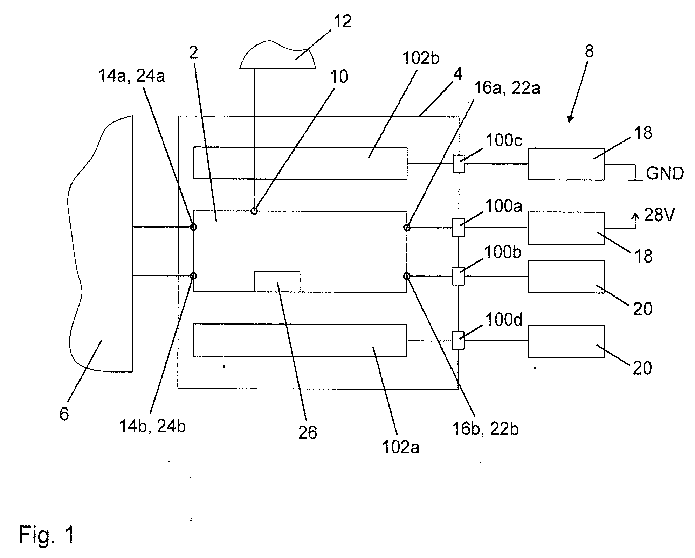

Fig. 1 zeigt eine erfindungsgemäße Schnittstellenschaltung 2 in einem Schnittstellenmodul 4, die zwischen eine Logikschaltung 6 und eine Leistungsschaltung 8 zwischengeschaltet ist. Über einen Versorgungsanschluss 10 ist die Schnittstellenschaltung an eine Energieversorgung 12 angeschlossen. Zwei Logikanschlüsse 14a,b dienen zum Anschluss an die Logikschaltung 6, zwei Leistungsanschlüsse 16a,b zum Anschluss an die Leistungsschaltung 8, bzw. an eine Last 18 und einen Schalter 20. Daher ist der Leistungsanschluss 16a als Leistungsausgang 22a und der Leistungsanschluss 16b als Leistungseingang 22b konfiguriert. Der Logikanschluss 14a ist als Logikeingang 24a zur Ansteuerung der Last 18, der Logikanschluss 14b als Logikausgang 24b zum Auslesen des Schalters 20 konfiguriert. Die Konfiguration erfolgt über eine Konfigurationseinheit 26.

Auch das Schnittstellenmodul 4 weist Leistungsanschlüsse 100a-d auf. Die Leistungsanschlüsse 16a,b der Schnittstellenschaltung 2 sind auf die Leistungsanschlüsse 100a,b des Schnittstellenmoduls 4 geführt.

Die Leistungsanschlüsse 100c,d sind am Schnittstellenmodul 4 zusätzlich vorhanden. Diesen sind ein dediziertes Eingangsmodul 102a und ein dediziertes Ausgangsmodul 102b zugeordnet. Daher ist der Leistungsanschluss 100c ein Leistungsausgang zum Treiben einer Last 18 und der Leistungsanschluss 100d ein Leistungseingang zum Auslesen eines Schalters 20, die nicht in Ein- bzw. Ausgänge umkonfigurierbar sind.

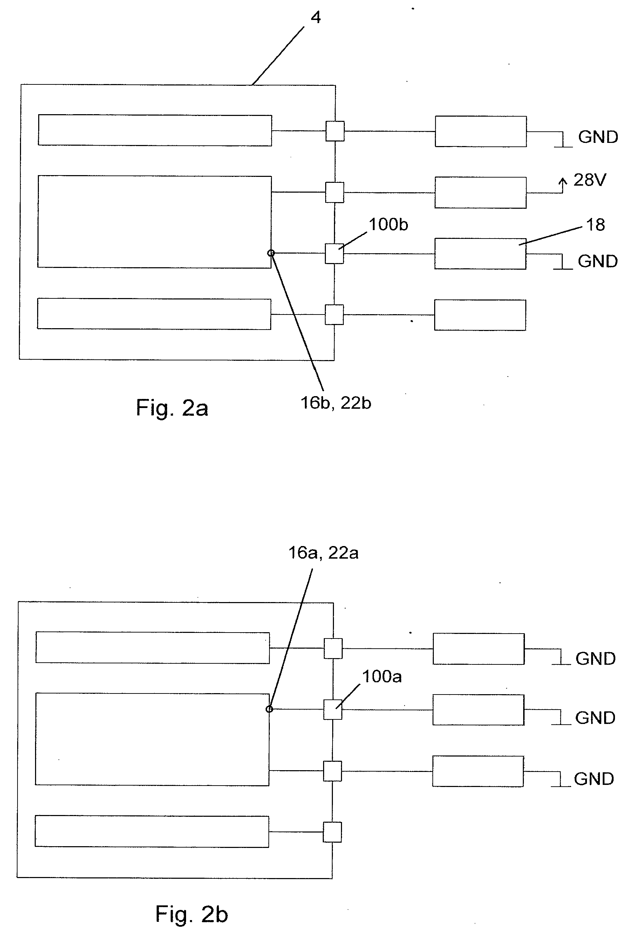

Fig. 2a zeigt das Schnittstellenmodul 4 aus Fig. 1 in alternativer Konfiguration. Am Leistungsanschluss 100b ist anstelle des Schalters 20 eine Last 18 angeschlossen. Der Leistungsanschluss 100b sowie der Leistungsanschluss 16b sind daher als Leistungsausgang 22a konfiguriert.

Fig. 2b zeigt eine weitere alternative Konfiguration des Schnittstellenmoduls 4. Hier ist der Leistungsanschluss 16a nach wie vor als Leistungsausgang 22a, jedoch hier zur Ansteuerung einer Last gegen Masse (GND) anstelle gegen Versorgungsspannung (28V) konfiguriert.

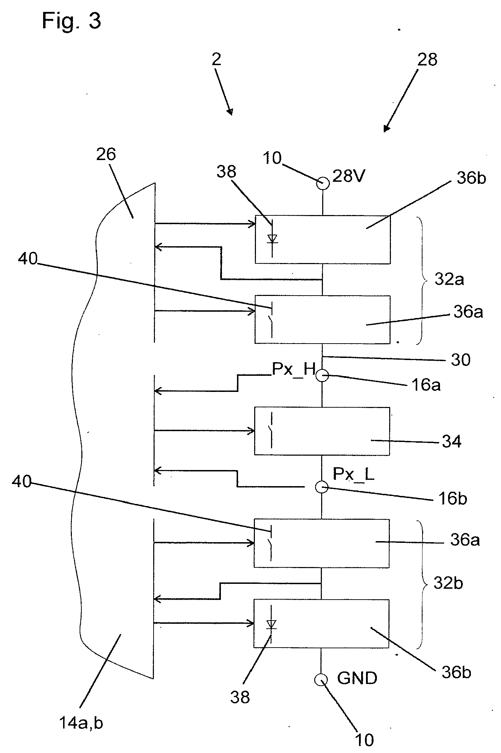

Fig. 3 zeigt die Schnittstellenschaltung 2 in Form einer Halbbrückenschaltung 28 mit einem Schaltzweig 30, der von einem Versorgungsanschluss 10a zur Versorgungsspannung 28V zu einem Versorgungsanschluss 10b zur Masse GND führt. Der Schaltzweig enthält in Reihenschaltung ein erstes Brückenelement 32a und ein zweites Brückenelement 32b mit einem dazwischen liegenden Trennschalter 34. Der erste Leistungsanschluss 16a liegt zwischen erstem Brückenelement 32a und Trennschalter 34, der zweite Leistungsanschluss 16b liegt zwischen zweitem Brückenelement 32b und Trennschalter 34. Die Brückenelemente 32a,b und der Trennschalter 34 sind von der Konfigurationseinheit 26 konfigurierbar. Letztere enthält auch bzw. führt zu den hier nicht näher gezeichneten Logikanschlüssen 14a,b. Hierzu dienen die gezeigten Verbindungsleitungen

Die Brückenelemente 34a,b sind als Reihenschaltung jeweils zweier Halbleiterschalter 36a,b ausgeführt. Der Halbleiterschalter 36a wird tatsächlich als Schalter 40 genutzt. Der Halbleiterschalter 36b weist eine parasitäre Diode auf: Dieser wird von der Konfigurationseinheit 26 so angesteuert, dass schaltungstechnisch die elektrischen Eigenschaften von dessen Diode genutzt werden. Mit anderen Worten wird der Halbleiterschalter 36b als konfigurierbare Diode 38 und nicht als eigentlicher Schalter 40 betrieben bzw. genutzt.

Im Detail werden über die Verbindungsleitungen die Gate-Source-Spannungen U_{GS} der Halbleiterschalter in den Brückenelementen 32a,b gesteuert, das Schaltkommando des Trennschalters 34 geliefert und die Spannungen der Leitungsabschnitte des Schaltzweigs 30 ausgelesen.

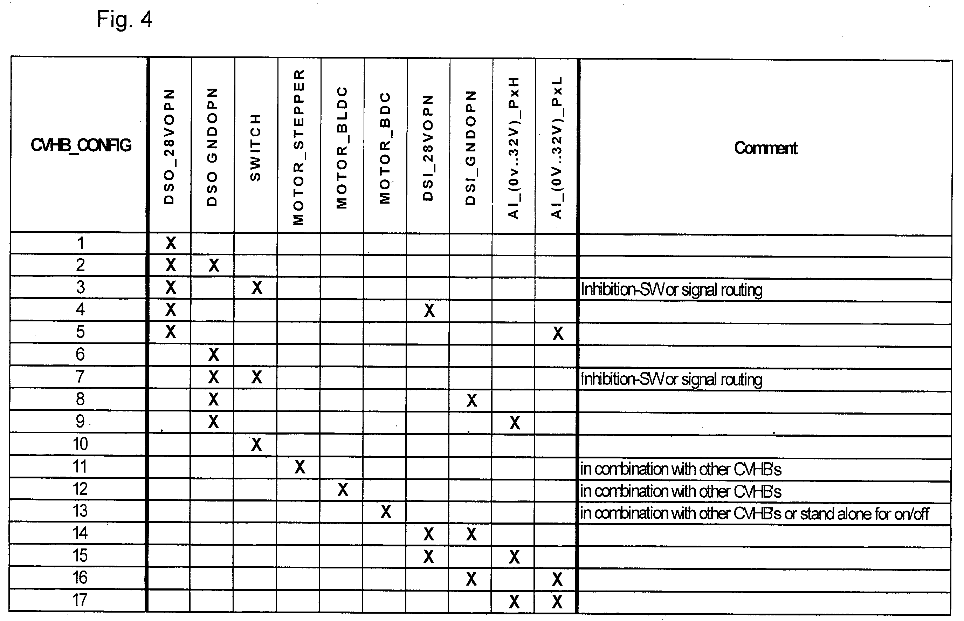

Fig. 4 zeigt tabellarisch 17 mögliche Konfigurationen der Halbbrückenschaltung 28 (hier abgekürzt als CVHB: Configurable Versatile Half Bridge) aus Fig. 3: Pro Konfiguration können maximal zwei herkömmliche Schnittstellenschaltungen realisiert werden; diese sind in Spalten von links nach rechts gesehen:
- ein DSO-Modul zum Treiben einer Last gegen pos. Versorgungsspannung (z.B. 28V)
- ein DSO-Modul zum Treiben einer Last gegen neg. Versorgungsspannung (z.B. GND)
- ein Schalter
- eine Schrittmotoransteuerung
- eine Ansteuerung eines bürstenlosen Gleichstrommotors (BLDC)
- eine Ansteuerung eines Gleichstrommotors mit Bürsten (BDC)
- ein DSI Modul für Eingänge gegen pos. Versorgungsspannung (z.B. 28V)
- ein DSI Modul für Eingänge gegen neg. Versorgungsspannung (z.B. GND)
- ein analoger Eingang (z.B. für Spannungen von 0 bis 32V) am ersten Leistungsanschluss 16a,
- ein analoger Eingang (z.B. für Spannungen von 0 bis 32V) am zweiten Leistungsanschluss 16b.

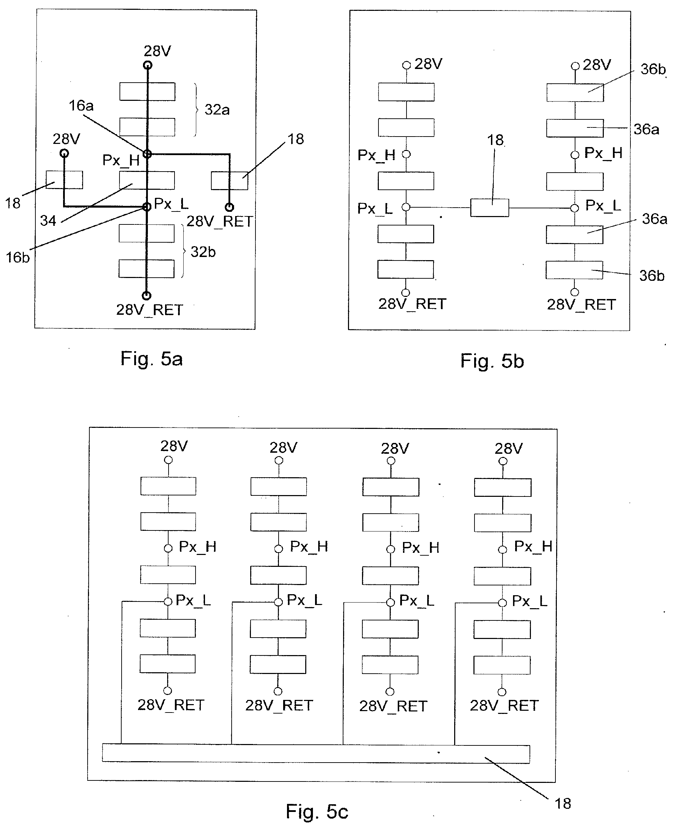

Fig. 5a-c zeigen jeweils identische Halbbrückenschaltungen 28, deren Elemente aus Gründen der Übersichtlichkeit nur einzeln stellvertretend für alle nummeriert sind. Fig. 5a zeigt die Halbbrückenschaltung 28 bei geöffnetem Trennschalter 34. Sowohl der TOPals auch der BOT-Teil der Halbbrücke können zum Treiben von Lasten 18 über die beiden Leistungsanschlüsse 16a,b genutzt werden.

Fig. 5b zeigt die Kombination zweier Halbbrückenschaltungen 28 zum Treiben einer Last 18 zwischen den jeweiligen Leistungsanschlüssen 16b, wobei Strom wahlweise in beiden Richtungen durch die Last geführt werden kann.

Fig. 5c zeigt die Kombination von vier Halbbrückenschaltungen 28 zur Ansteuerung eines Schrittmotors oder eines BLDC-Motors als Last 18, jeweils angeschlossen an den Leistungsanschlüssen 16b.

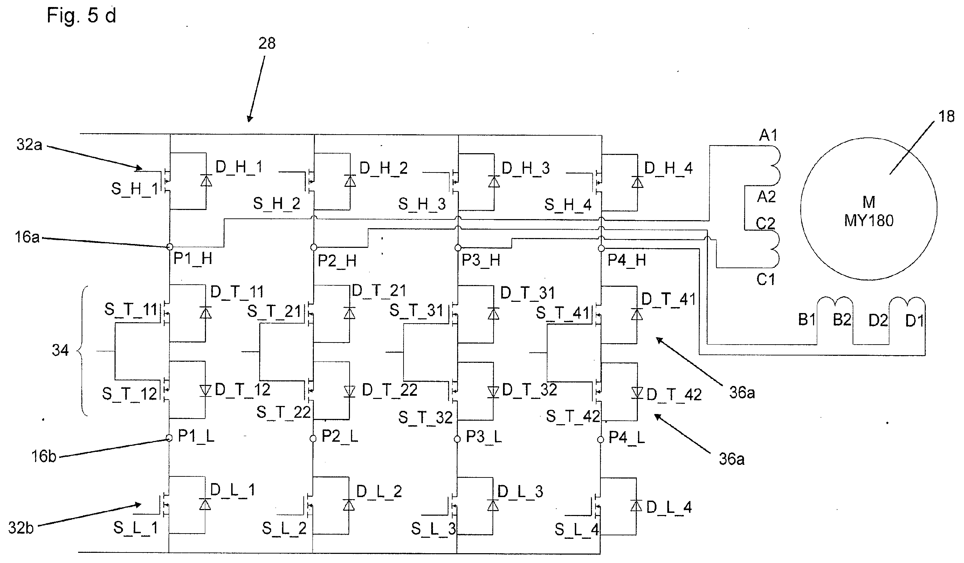

Fig. 5d zeigt nochmals die Kombination von vier identischen, jedoch alternativen Halbbrückenschaltungen 28 zum Ansteuern eines seriellen bipolaren Schrittmotors als Last 18. Hier sind die Trennschalter 34 konkret als Reihenschaltung zweier Halbleiterschalter 36a ausgeführt, deren parsitäre Dioden antiparallel ausgerichtet sind.

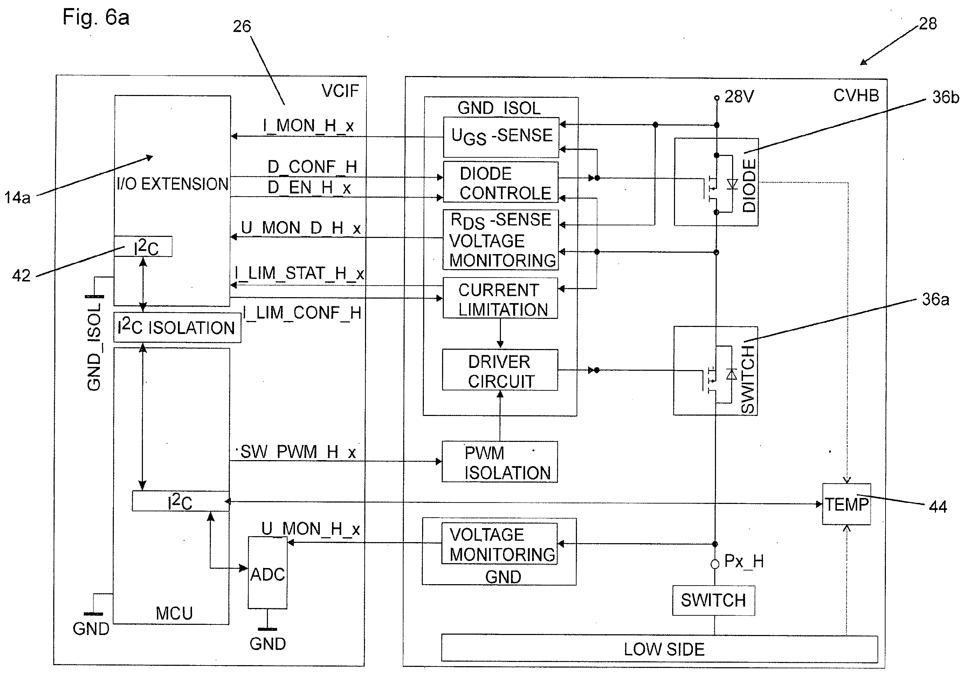

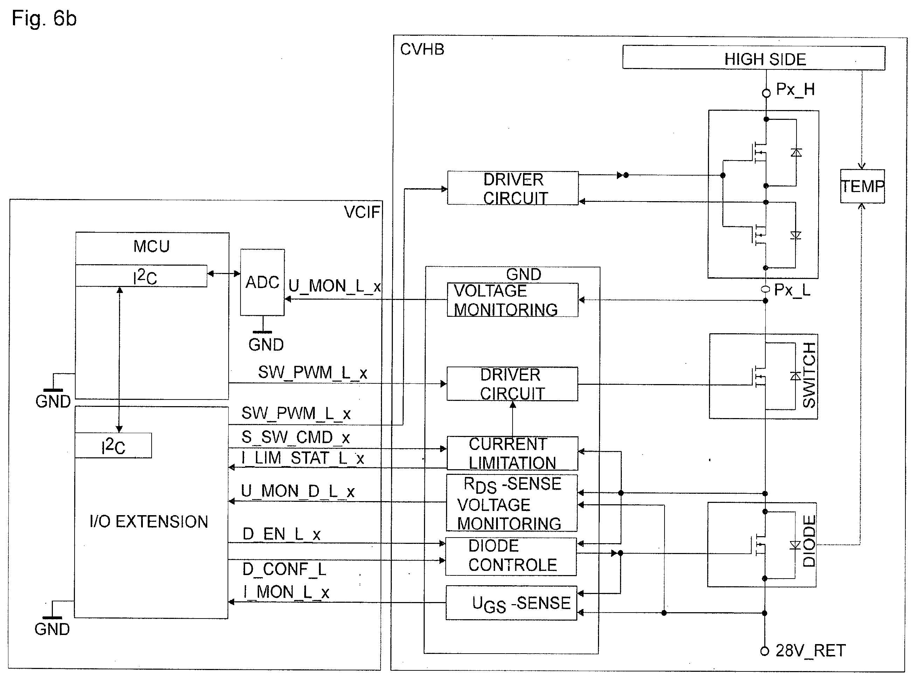

Fig. 6a zeigt den TOP-Teil (in Fig. 6b als Platzhalter "HIGH SIDE" dargestellt) der Halbbrückenschaltung 28, Fig. 6b deren Trennschalter 34 (in Fig. 6a als Platzhalter "SWITCH" dargestellt) und BOT-Teil (in Fig. 6a als PLatzhalter "LOW SIDE" dargestellt). Die Konfigurationseinheit 26 ist hier auch als VCIF (Versatile Configuration Interface) bezeichnet und beinhaltet die Logikanschlüsse 14a,b in Form von I²C-Busanschlüssen 42. Die Bezeichnungen in den Figuren sind selbsterklärend und bezeichnen z.B. einen Temperatursensor 44 "TEMP", eine Monitoring-Schaltung zur Überwachung einer Gate-Source-Spannung "U_{GS}-Sense", einen Analog-Digital-Umsetzer 46, eine Mikrorechnereinheit "MCU" usw.

### Bezugszeichenliste

- 2: Schnittstellenschaltung
- 4: Schnittstellenmodul
- 6: Logikschaltung
- 8: Leistungsschaltung
- 10,10a,b: Versorgungsanschluss
- 12: Energieversorgung
- 14a,b: Logikanschluss
- 16a,b: Leistungsanschluss
- 18: Last
- 20: Schalter
- 22a: Leistungsausgang
- 22b: Leistungseingang
- 24a: Logikeingang
- 24b: Logikausgang
- 26: Konfigurationseinheit
- 28: Halbbrückenschaltung
- 30: Schaltzweig
- 32a,b: Brückenelement
- 34: Trennschalter
- 36a,b: Halbleiterschalter
- 38: Diode
- 40: Schalter
- 42: I²C-Busanschluss
- 44: Temperatursensor
- 46: Analog-Digital-Umsetzer
- 100a-d: Leistungsanschluss
- 102a: Eingangsmodul
- 102b: Ausgangsmodul

## Patentansprüche

1. Schnittstellenschaltung (2) zur Zwischenschaltung zwischen eine Logikschaltung (6), die den Logikteil einer elektrischen Schaltung darstellt, und eine Leistungsschaltung (8), die den Leistungsteil der elektrischen Schaltung darstellt, mit einem Versorgungsanschluss (10) zum Anschluss an eine Energieversorgung (12),
wobei
- die Schnittstellenschaltung (2) zwei Logikanschlüsse (14a,b) zum jeweiligen Anschluss an die Logikschaltung (6), die als Logikeingang (24a) oder Logikausgang (24b) konfigurierbar sind,
- und zwei Leistungsanschlüsse (16a,b) zum jeweiligen Anschluss an die Leistungsschaltung (8), die als Leistungseingang (22b) oder Leistungsausgang (22a) konfigurierbar sind,
- und eine Konfigurationseinheit (26) zur Konfiguration der Logikanschlüsse (14a,b) und der Leistungsanschlüsse (16a,b) enthält,
- wobei der Leistungseingang (22b) durch den Logikausgang (24b) auslesbar ist und der Leistungsausgang (22a) durch den Logikeingang (24a) ansteuerbar ist, wobei die Schnittstellenschaltung (2) als Halbbrückenschaltung (28) ausgeführt ist,
- mit einem Schaltzweig (30), der von einem ersten (10a) zu einem zweiten Versorgungsanschluss (10b) führt, und der in Reihenschaltung enthält:
- ein erstes (32a) und ein zweites Brückenelement (32b), das jeweils von der Konfigurationseinheit (26) konfigurierbar ist, um von einem Logikeingang (24a) ansteuerbar oder von einem Logikausgang (24b) auslesbar zu sein,
- einen Trennschalter (34), der zwischen erstem (32a) und zweitem Brückenelement (32b) angeordnet ist und der von der Konfigurationseinheit (26) schaltbar ist,
- den ersten Leistungsanschluss (16a), der zwischen erstem Brückenelement (32a) und Trennschalter (34) angeordnet ist,
- den zweiten Leistungsanschluss (16b), der zwischen zweitem Brückenelement (32b) und Trennschalter (34) angeordnet ist.

2. Schnittstellenschaltung (2) nach Anspruch 1, bei der jedes der Brückenelemente (32a,b) mindestens einen, insbesondere mindestens zwei in Reihe geschaltete, steuerbare Halbleiterschalter (36a,b) enthält.

3. Schnittstellenschaltung (2) nach Anspruch 2, bei der mindestens einer der Halbleiterschalter (36a,b) einen MOS-FET mit parasitärer Substratdiode enthält.

4. Schnittstellenschaltung (2) nach Anspruch 3, bei dem mindestens einer der Halbleiterschalter(36b) in Verbindung mit der Konfigurationseinheit (26) derart eingerichtet ist, dass durch dessen Ansteuerung die elektrischen Eigenschaften seiner parasitären Substratdiode als steuerbare Diode (38) gezielt festgelegt sind.

5. Schnittstellenschaltung (2) nach einem der vorhergehenden Ansprüche, bei der der Trennschalter (34) zwei in Reihenschaltung angeordnete steuerbare Halbleiterschalter (36a,b) enthält.

6. Schnittstellenschaltung (2) nach Anspruch 5, bei der die Halbleiterschalter (36a,b) jeweils MOS-FET mit jeweiliger parasitärer Substratdiode enthalten, wobei deren Substratdioden bezüglich der Reihenschaltung entgegengesetzt gerichtet sind.

7. Schnittstellenmodul (4), mit mindestens zwei Leistungsanschlüssen (100a,b), **dadurch gekennzeichnet, dass** das Schnittstellenmodul (4) mindestens eine Schnittstellenschaltung (2) nach einem der Ansprüche 1 bis 6 enthält, deren Leistungsanschlüsse (16a,b) auf die Leistungsanschlüsse (100a,b) des Schnittstellenmoduls (4) geführt sind.

8. Schnittstellenmodul (4) nach Anspruch 7, mit zusätzlichen Leistungsanschlüssen (100c,d), wobei das Schnittstellenmodul (4) für jeden der Leistungsanschlüsse (100c,d) eine spezielle Eingangs- (102a) oder Ausgangsschnittstelle (102b) enthält.

## Claims

1. Interface circuit (2) for intermediate connection between a logic circuit (6), which represents the logic part of an electrical circuit, and a power circuit (8), which represents the power part of the electrical circuit, having a supply connection (10) for connection to a power supply (12), wherein
- the interface circuit (2) contains two logic connections (14a,b) to the respective connection on the logic circuit (6), which logic connections are configurable as logic input (24a) or logic output (24b),
- and two power connections (16a,b) to the respective connection on the power circuit (8), which power connections are configurable as power input (22b) or power output (22a),
- and a configuration unit (26) for configuring the logic connections (14a,b) and the power connections (16a,b),
- wherein the power input (22b) can be read by the logic output (24b) and the power output (22a) can be driven by the logic input (24a),
wherein the interface circuit (2) is designed as half-bridge circuit (28),
- having a switching branch (30), which is routed from a first (10a) to a second supply connection (10b) and which contains, in a series connection:
- a first (32a) and a second bridge element (32b), which are each configurable by the configuration unit (26) in order to be able to be driven by a logic input (24a) or to be able to be read by a logic output (24b),
- a disconnecting switch (34), which is arranged between the first (32a) and second bridge element (32b) and can be switched by the configuration unit (26),
- the first power connection (16a), which is arranged between the first bridge element (32a) and the disconnecting switch (34),
- the second power connection (16b), which is arranged between the second bridge element (32b) and the disconnecting switch (34).

2. Interface circuit (2) according to Claim 1, in which each of the bridge elements (32a,b) contains at least one, in particular at least two series-connected controllable semiconductor switches (36a,b).

3. Interface circuit (2) according to Claim 2, in which at least one of the semiconductor switches (36a,b) contains a MOSFET with a parasitic substrate diode.

4. Interface circuit (2) according to Claim 3, in which at least one of the semiconductor switches (36b) is set up in a manner connected to the configuration unit (26) such that, by virtue of said semiconductor switch being driven, the electrical properties of its parasite substrate diode as controllable diode (38) are determined in a targeted manner.

5. Interface circuit (2) according to any of the preceding claims, in which the disconnecting switch (34) contains two series-connected controllable semiconductor switches (36a,b).

6. Interface circuit (2) according to Claim 5, in which the semiconductor switches (36a,b) in each case contain MOSFETs with respective parasitic substrate diodes, wherein the substrate diodes of said MOSFETs are oriented in reverse bias with respect to the series connection.

7. Interface module (4), having at least two power connections (100a,b), **characterized in that** the interface module (4) contains at least one interface circuit (2) according to any of Claims 1 to 6, the power connections (16a,b) of which interface circuit are routed to the power connections (100a,b) of the interface module (4).

8. Interface module (4) according to Claim 7, having additional power connections (100c,d), wherein the interface module (4) contains a specific input (102a) or output interface (102b) for each of the power connections (100c,d).

## Revendications

1. Circuit d'interface (2) destiné à être interconnecté entre un circuit logique (6) qui représente la partie logique d'un circuit électrique, et un circuit de puissance (8), qui représente la partie puissance du circuit électrique, comprenant une borne d'alimentation (10) destinée à être raccordée à une source d'alimentation en énergie (12),
- le circuit d'interface (2) comprenant deux bornes logiques (14a, b) destinées à être raccordées respectivement au circuit logique (6), lesquelles peuvent être configurées comme entrée logique (24a) ou sortie logique (24b),
- et deux bornes de puissance (16a, b) destinées à être raccordées respectivement au circuit de puissance (8), lesquelles peuvent être configurées comme entrée de puissance (22b) ou sortie de puissance (22a),
- et une unité de configuration (26) destinée à la configuration des bornes logiques (14a, b) et des bornes de puissance (16a, b),
- l'entrée de puissance (22b) pouvant être lue par la sortie logique (24b) et la sortie de puissance (22a) pouvant être commandée par l'entrée logique (24a),
le circuit d'interface (2) étant réalisé sous la forme d'un circuit en demi-pont (28),
- comprenant une branche de commutation (30) qui mène d'une première (10a) à une deuxième borne d'alimentation (10b), et qui comprend, branchés en série :
- un premier (32a) et un deuxième élément de pont (32b) qui peuvent respectivement être configurés par l'unité de configuration (26) afin de pouvoir être commandés par une entrée logique (24a) ou être lus par une sortie logique (24b),
- un sectionneur (34) qui est disposé entre le premier (32a) et le deuxième élément de pont (32b) et qui peut être commuté par l'unité de configuration (26),
- la première borne de puissance (16a), qui est disposée entre le premier élément de pont (32a) et le sectionneur (34),
- la deuxième borne de puissance (16b), qui est disposée entre le deuxième élément de pont (32b) et le sectionneur (34).

2. Circuit d'interface (2) selon la revendication 1, avec lequel chacun des éléments de pont (32a, b) contient au moins un, notamment au moins deux commutateurs semiconducteurs (36a, b) commandables branchés en série.

3. Circuit d'interface (2) selon la revendication 2, avec lequel au moins l'un des commutateurs semiconducteurs (36a, b) contient un MOS-FET avec diode de substrat parasite.

4. Circuit d'interface (2) selon la revendication 3, avec lequel au moins l'un des commutateurs semiconducteurs (36b), en association avec l'unité de configuration (26), est configuré de telle sorte que sa commande permet de définir de manière ciblée les propriétés électriques de sa diode de substrat parasite en tant que diode commandable (38).

5. Circuit d'interface (2) selon l'une des revendications précédentes, avec lequel le sectionneur (34) comprend deux commutateurs semiconducteurs (36a, b) commandables branchés en série.

6. Circuit d'interface (2) selon la revendication 5, avec lequel les commutateurs semiconducteurs (36a, b) contiennent respectivement un MOS-FET avec une diode de substrat parasite correspondante, leurs diodes de substrat étant dirigées en sens inverse par rapport au branchement en série.

7. Module d'interface (4) comprenant au moins deux bornes de puissance (100a, b), **caractérisé en ce que** le module d'interface (4) comprend au moins un circuit d'interface (2) selon l'une des revendications 1 à 6 dont les bornes de puissance (16a, b) sont amenées sur les bornes de puissance (100a, b) du module d'interface (4).

8. Module d'interface (4) selon la revendication 7, comprenant des bornes de puissance supplémentaires (100c, d), le module d'interface (4) comprenant une interface d'entrée (102a) ou de sortie (102b) spéciale pour chacune des bornes de puissance (100c, d).
